# EUROPEAN PATENT APPLICATION

(11) **EP 4 810 970 A1**
(43) Date of publication of application: **23.09.2026**
(21) Application number: 26155238.4
(22) Date of filing: 30.01.2026
(51) Int. Cl.: G01R 31/327

(54) **POWER BATTERY SYSTEM AND METHOD FOR SWITCH ADHESION THEREOF**

(30) Priority: 17.03.2025 CN 202510314708
(71) Applicant: Robert Bosch GmbH, 70442 Stuttgart (DE)
(72) Inventor: LIU, Xinchao, Wuxi, Jiangsu 214028 (CN); HUANG, Guigen, Wuxi, Jiangsu 214028 (CN)
(74) Representative: Isarpatent

(57) **Abstract**

A power battery system comprising: a power battery, a positive bus bar, and a negative bus bar, with a main positive switch provided in the positive bus bar and a main negative switch provided in the negative bus bar; a DC bus capacitor connected between a load side of the positive bus bar and a load side of the negative bus bar; a pre-charge line connected to the positive bus bar on the battery side and the load side of the main positive switch, the pre-charge line being provided with an adhesion detection switch, a pre-charge resistor, and a pre-charge switch; and an adhesion detection line connected between the pre-charge circuit and the negative bus bar, the adhesion detection circuit including at least one voltage divider resistor. Based on various switch states of each switch, the battery voltage on both sides of the power battery, the capacitor voltage on both sides of the DC bus capacitor, and the sampling voltage on both sides of the adhesion detection line are obtained. Based on the on/off states of each switch in various combinations of switch states, as well as the values of the capacitor voltage and the sampling voltage, the adhesion of the adhesion detection switch, the main positive switch, the main negative switch, and the pre-charge switch is determined.

## Description

### Technical Field

The present application relates to a power battery system such as that used in a new energy vehicle and an associated detection method of switch adhesion.

### Background

The power battery (high voltage battery) of the new energy vehicle outputs electrical energy to the electrical load through positive and negative bus bars. When the power battery is not in use, or in a vehicle emergency, the power battery needs to be isolated from the electrical load to ensure high-voltage safety. To this end, switches are provided in the positive bus bar and the negative bus bar respectively, which may be referred to as the main positive switch and the main negative switch. In addition, a pre-charge line is typically provided in parallel with the main positive switch. Once the switches in the positive and negative bus bars are stuck, they need to be detected at least before the vehicle is activated to avoid various high-voltage safety risks. Further, if the main positive switch is inadvertently stuck and the adhesion fault of the main positive switch is not detected before the main negative switch is closed, the high voltage difference across the main negative switch when it is closed tends to cause the main negative switch to stick.

Various switch adhesion detection protocols are in place to detect switch adhesion failures in the positive and negative bus bars of the power battery. One issue with the existing switch adhesion detection protocol is that there is a high-voltage safety risk due to the difficulty of achieving complete electrical isolation. For example, in an existing power battery system, a cross-voltage adhesion detection line is provided with one end connected to the positive bus bar on the load side (DC bus capacitor side) and the other end connected to the negative bus bar on the battery side. Switch adhesion detection is achieved by utilizing the voltage between the two ends of the adhesion detection line. In this approach, complete electrical isolation between the battery side and the load side cannot actually be achieved due to the presence of this adhesion detection line. In addition, another problem with the current switch adhesion detection protocol is the difficulty of achieving the adhesion detection of the main positive switch and the main negative switch through a single detection process.

### Summary of the Invention

The present application is intended to provide a scheme for more efficiently detecting switch adhesion faults in a power battery system.

According to an aspect of the present application, a power battery system is provided, comprising
a power battery;
a positive bus bar and a negative bus bar, respectively connected to positive and negative terminals of the power battery, and used to output the electric energy of the power battery to the electric load, a main positive switch being provided in the positive bus bar, and a main negative switch being provided in the negative bus bar;
a DC bus capacitor connected between a load side of the positive bus bar and a load side of the negative bus bar;
a pre-charge line, respectively connected to the positive bus bar on both the battery side and the load side of the main positive switch, the pre-charge line being provided with an adhesion detection switch, a pre-charge resistor, and a pre-charge switch; and
an adhesion detection line connected between the pre-charge line and the negative bus bar, the adhesion detection line including at least one pressure divider resistor;
wherein the connection point between the adhesion detection line and the pre-charge line is on the battery side of the pre-charge switch, and the connection point between the adhesion detection line and the negative bus bar is on the battery side of the main negative switch.

According to another aspect of the present application, a method of switch adhesion detection that can be used in the power battery system comprises:
acquiring battery voltage on both sides of the power battery, capacitor voltage on both sides of the DC bus capacitor, sampling voltage on the adhesion detection line in a variety of combined switch states based on the on/off states of each of the adhesion detection switch, the main positive switch, the main negative switch, and the pre-charge switch;
determining the adhesion of the adhesion detection switch, the main positive switch, the main negative switch, and the pre-charge switch based on the on/off state of each switch in the various combined switch states and the values of the capacitor voltage and the sampling voltage.

According to the power battery system of the present application and the method of switch adhesion detection thereof, by adding an adhesion detection switch in the pre-charge line and an adhesion detection line between the pre-charge line and the negative bus bar, the adhesion of the main positive switch, the main negative switch, and the pre-charge switch can be detected in a single detection process, and complete electrical isolation between the battery side and the load side can be achieved.

### Brief Description of the Drawings

For a better understanding of the foregoing and other aspects of the present application, a detailed description will be provided with reference to the drawings below, wherein
FIG. 1 is a schematic view of a power battery system according to one embodiment of the present application;
FIG. 2, FIG. 3 are schematic diagrams of a modification of a power battery system of the present application;
FIG. 4 is a flow chart of an example switch adhesion detection program that may be employed by the power battery system shown in FIG. 1.

### Detailed Description of the Embodiments

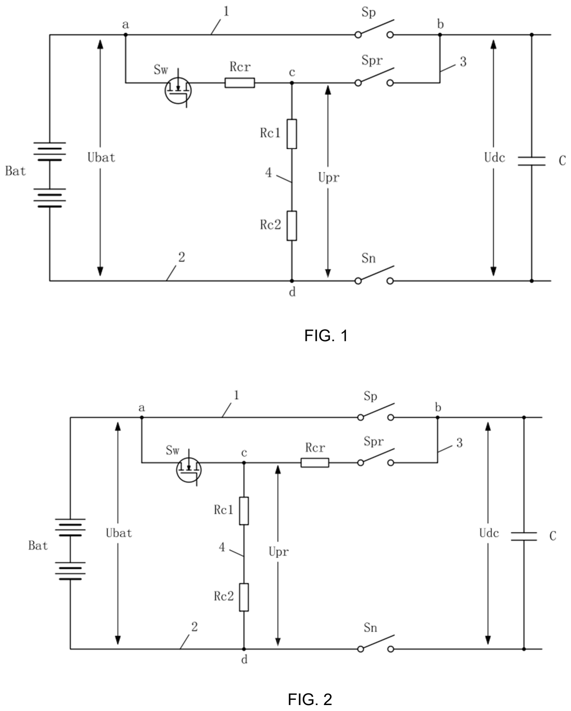

The present application generally relates to a power battery system for use in a new energy vehicle, etc. One example implementation of the power battery system is shown in FIG. 1.

Referring to FIG. 1, the power battery system includes a power battery (high voltage battery) Bat, which may be a battery or a fuel cell, etc. The positive and negative terminals of the power battery Bat are respectively coupled to a positive bus bar (main positive line) 1 and a negative bus bar (main negative line) 2 for outputting the electrical energy of the power battery Bat to an electrical load (not shown, e.g., a drive motor of a new energy vehicle, etc.).

A main positive switch Sp and a main negative switch Sn are respectively provided in the positive bus bar 1 and the negative bus bar 2. The main positive switch Sp and the main negative switch Sn are typically a contactor, for controlling the connection and disconnection between the battery side and the load side.

"Battery side" used in the present application to define the relative position of various elements in the power battery system refers to the side relatively proximate to the power battery Bat, and "load side" refers to the side relatively proximate to the load (i.e., away from the power battery Bat).

On the load side relative to the main positive switch Sp and the main negative switch Sn, a DC bus bar capacitor C is provided between the positive bus bar 1 and the negative bus bar 2 for inhibiting system voltage fluctuations, etc.

To prevent switch adhesion due to the high potential differential creating an arc in the main positive switch Sp when the main positive switch Sp is closed, a pre-charge line 3 in parallel with the main positive switch Sp is provided for the positive bus bar 1. One end of the pre-charge line 3 is connected to the positive bus bar 1 at an upstream connection point a and the other end is connected to the positive bus bar 1 at a downstream connection point b. The upstream connection point a is on the battery side relative to the main positive switch Sp and the downstream connection point b is on the load side relative to the main positive switch Sp.

A pre-charge switch Spr is provided in the pre-charge line 3, which is typically a contactor, for controlling the on/off of the pre-charge line 3. A pre-charge resistor Rcr is also provided in the pre-charge line 3, which is generally on the battery side relative to the pre-charge switch Spr. Further, on the battery side relative to the pre-charge resistor Rcr, an additional adhesion detection switch Sw is provided in the pre-charge line 3, which is a semiconductor switch, such as a transistor switch.

The addition of a semiconductor switch (particularly a transistor switch) to the pre-charge line 3 as an adhesion detection switch Sw is relatively low cost and easy to control.

Further, an adhesion detection line 4 is provided between the pre-charge line 3 and the negative bus bar 2. The adhesion detection line 4 may include two or more voltage divider resistors in series with each other, such as the voltage divider resistors Rc1, Rc2 shown in FIG. 1, but the number of voltage divider resistors in the adhesion detection line 4 is not so limited. One end of the adhesion detection line 4 is connected to the pre-charge line 3 at a first connection point c and the other end is connected to the negative bus bar 2 at a second connection point d. The first connection point c is located on the pre-charge line 3 on the battery side relative to the pre-charge switch Spr, e.g., between the pre-charge resistor Rcr and the pre-charge switch Spr shown in FIG. 1. The second connection point d is located on the negative bus bar 2 on the battery side relative to the main negative switch Sn.

The power battery system of the present application enables adhesion detection of the pre-charge switch Spr, the main positive switch Sp, and the main negative switch Sn through a single adhesion detection process before the power battery Bat supplies power to the load. To this end, the following three voltage values need to be measured during the adhesion detection process: a battery voltage Ubat, a sampling voltage Upr, and a capacitor voltage Udc.

The battery voltage Ubat is taken from both sides of the power battery Bat, e.g., between the positive bus bar section on the battery side relative to the upstream connection point a and the negative bus bar section on the battery side relative to the second connection point d, to represent the output voltage of the power battery Bat. It is noted that the battery voltage Ubat is typically monitored by a battery management module (not shown). The battery management module allows the power battery Bat to output voltage only if the battery voltage Ubat is above a set voltage threshold. Accordingly, the power battery system of the present application performs switch adhesion detection only in a state where the battery voltage Ubat is above a set voltage threshold.

The capacitor voltage Udc is taken from both sides of the DC bus capacitor C, for example, between the positive bus bar section on the load side relative to the downstream connection point b and the negative bus bar section on the load side relative to the main negative switch Sn.

The sampling voltage Upr is used to represent the voltage level of the pre-charge line 3. The selection of the measurement point of the sampling voltage Upr has great flexibility. For example, as shown in FIG. 1, it can be taken from both sides of the adhesion detection line 4, i.e., between the positive bus bar section where the first connection point c is located and the negative bus bar section where the second connection point d is located. Alternatively, the sampling voltage Upr may be taken from either one or more voltage divider resistor sides, for example, from both sides of the voltage divider resistor Rc1, or from both sides of the voltage divider resistor Rc2. The sampling voltage, Upr, represents the voltage dispensed by the battery voltage, Ubat, on the voltage divider resistor. In the state where the pre-charge switch Spr, the main positive switch Sp, and the main negative switch Sn are all normally disconnected, if the adhesion detection switch Sw is normally connected, the circuit comprising the pre-charge resistor Rcr and the voltage divider resistor in series between the positive and negative terminals of the power battery Bat is in the communication state, and the sampling voltage Upr shall reach a reference value. The proportional relationship between the sampling voltage reference value and the battery voltage Ubat may be calculated by the pre-charge resistor Rcr and the voltage divider resistor. At this point, the sampling voltage reference value is Upr0 = k*Ubat, and the value of k is dependent on the measurement point of the sampling voltage Upr.

Battery voltages and capacitor voltages are typically monitored in conventional power battery systems. In the power battery system of the present application, the adhesion detection program is implemented, wherein the sampling voltage Upr is measured in addition to the acquisition of the battery voltage Ubat and the capacitor voltage Udc.

The basic concept of the adhesion detection program of the present application is that the adhesion detection of the pre-charge switch Spr, the main positive switch Sp, and the main negative switch Sn is achieved based on the measured values of the three voltages under various different on/off combinations of the adhesion detection switch Sw, the pre-charge switch Spr, the main positive switch Sp, and the main negative switch Sn.

First, considering the need to minimize the power battery Bat discharge during the adhesion detection procedure, only one of the pre-charge switch Spr, the main positive switch Sp, and the main negative switch Sn is closed at each step of the adhesion detection procedure, while the other two switches are disconnected. Therefore, there are eight possible switch combination states that can be used in the adhesion detection procedure of the present application, as listed below.

Switch state 1: The adhesion detection switch Sw is off, the main positive switch Sp, the pre-charge switch Spr, and the main negative switch Sn are all disconnected. In this state, if the sampling voltage is Upr = 0, it is determined that the adhesion detection switch Sw is normal; if the sampling voltage is Upr = the sampling voltage reference value Upr0, it is determined that the adhesion detection switch Sw is short-circuited (adhesive); if the capacitor voltage is Udc = the battery voltage Ubat, it is determined that the main positive switch Sp and the main negative switch Sn are all adhesive.

Switch state 2: The adhesion detection switch Sw is off, the main positive switch Sp is closed, and the pre-charge switch Spr and the main negative switch Sn are all disconnected. In this state, if the sampling voltage is Upr = 0, then the pre-charge switch is determined to be normal; if the sampling voltage is Upr = battery voltage Ubat, then the pre-charge switch is determined to be adhesive; if the capacitor voltage is Udc = 0, then the main negative switch is determined to be normal; if the capacitor voltage is Udc = battery voltage Ubat, then the main negative switch is determined to be adhesive; if the sampling voltage is Upr = the sampling voltage reference value Upr0, then the adhesion detection switch Sw is determined to be short-circuited.

Switch state 3: The adhesion detection switch Sw is off, the pre-charge switch Spr is closed, and the main positive switch Sp and the main negative switch Sn are all disconnected. In this state, if the sampling voltage is Upr = 0, then the main positive switch Sp is determined to be normal; if the sampling voltage is Upr = battery voltage Ubat, then the main positive switch Sp is determined to be adhesive; if the capacitor voltage Udc = battery voltage Ubat, then the main positive switch Sp and the main negative switch Sn are all determined to be adhesive; if the sampling voltage is Upr = sample voltage reference value Upr0, the adhesive detection switch Sw is determined to be short-circuited.

Switch state 4: The adhesion detection switch Sw is off, the main negative switch Sn is closed, and the main positive switch Sp and the pre-charge switch Spr are all disconnected. In this state, if the capacitor voltage is Udc = 0, then the main positive switch Sp is determined to be normal; if the capacitor voltage is Udc = battery voltage Ubat, then the main positive switch Sp is determined to be adhesive; if the sampling voltage is Upr = the sampling voltage reference value Upr0, then the adhesion detection switch Sw is short-circuited.

Switch state 5: The adhesive detection switch Sw is connected, and the main positive switch Sp, the pre-charge switch Spr, and the main negative switch Sn are all disconnected. In this state, if the capacitor voltage Udc = battery voltage Ubat, it is determined that the main positive switch Sp and the main negative switch Sn are both adhesive; if the capacitor voltage Udc = sampling voltage Upr, it is determined that the main negative switch Sn and the pre-charge switch Spr are both adhesive.

Switch state 6: The adhesion detection switch Sw is connected, the main positive switch Sp is closed, and the pre-charge switch Spr and the main negative switch Sn are both disconnected. In this state, if the sampling voltage Upr = sampling voltage reference value Upr0, then the pre-charge switch Spr is determined to be normal; if the sampling voltage Upr = battery voltage Ubat, then the pre-charge switch Spr is determined to be adhesive; if the capacitor voltage Udc = 0, the main negative switch Sn is determined to be normal; if the capacitor voltage Udc = battery voltage Ubat, then the main negative switch Sn is determined to be adhesive.

Switch state 7: The adhesion detection switch Sw is connected, the pre-charge switch Spr is closed, and the main positive switch Sp and the main negative switch Sn are both disconnected. In this state, if the capacitor voltage Udc = 0, it is determined that the main negative switch Sn is normal; if the capacitor voltage Udc = sample voltage Upr, it is determined that the main negative switch Sn is adhesive; if the capacitor voltage Udc = battery voltage Ubat, it is determined that the main positive switch Sp and the main negative switch Sn are both adhesive.

Switch state 8: The adhesion detection switch Sw is connected, the main negative switch Sn is closed, and the main positive switch Sp and the pre-charge switch Spr are both disconnected. In this state, if the capacitor voltage is Udc = 0, it is determined that the main positive switch Sp and the pre-charge switch Spr are normal; if the capacitor voltage is Udc = sample voltage Upr, it is determined that the pre-charge switch Spr is adhesive; if the capacitor voltage is Udc = battery voltage Ubat, it is determined that the main positive switch Sp is adhesive.

The adhesion detection procedure of the present application first detects if the adhesion detection switch Sw is short-circuited (adhesive). To this end, one of the above-mentioned switch states 1 to 4 can be used to determine if the adhesion detection switch Sw is short-circuited. Given that each switch is in a disconnected state when not in use by the power battery system, in order to determine whether the adhesion detection switch Sw is short-circuited with minimal switching actions, it is preferable to use the switch state 1 to detect the adhesion detection switch Sw. Using the switch state 1, it can also be determined that both the main positive switch Sp and the main negative switch Sn are adhesive, although the probability of both the main positive switch Sp and the main negative switch Sn being adhesive simultaneously is very low in reality.

Upon determining that the adhesion detection switch Sw is not short-circuited, it is to detect whether the main positive switch Sp, the pre-charge switch Spr, and the main negative switch Sn are adhesive. This can be achieved using some of the switch states 2 to 7.

In order to improve the accuracy and reliability of the judgment, one of the switch states can be selected to determine whether an adhesion is present for each of the main positive switch Sp, the pre-charge switch Spr, and the main negative switch Sn. In other words, three switch states of the switch states 2 to 7 are selected and each switch state is used to determine if one of the main positive switch Sp, the pre-charge switch Spr, and the main negative switch Sn is adhesive. In this way, the efficiency of adhesion detection can be improved.

However, more than three of the switch states 2 to 7 can also be selected to achieve adhesion detection of the main positive switch Sp, the pre-charge switch Spr, and the main negative switch Sn. In this case, redundant judgment results will appear. Using these redundant judgment results to verify each other can improve the accuracy of adhesion detection.

The selection of switch states and their execution order can be comprehensively optimized to minimize the number of switch on/off changes involved in the entire adhesion detection procedure.

Furthermore, considering the need to avoid discharging of the power battery Bat during the adhesion detection procedure, switch states requiring the main positive switch Sp to be closed (i.e., the switch states 2 and 6) can be excluded, meaning only switch states where the main positive switch Sp is disconnected are selected.

The adhesion detection procedure of the present application may be performed in a battery management module of a power battery. For example, a control module may be equipped to perform the adhesion detection program. The control module can be integrated into the battery management module, or it can be set up independently of the battery management module and called by the battery management module.

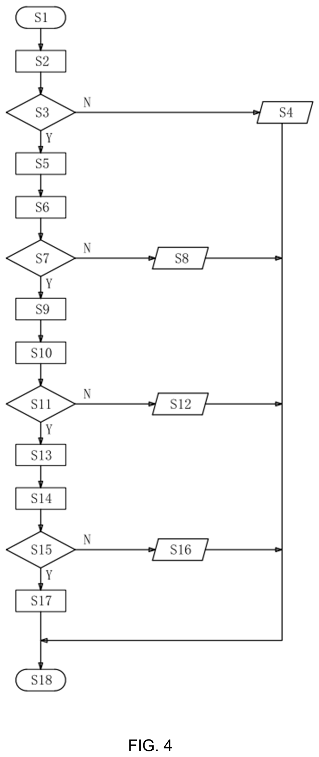

As one example, the adhesion detection program of the present application performs the above-described switch states 1, 3, 8, 7 in turn, thereby enabling detection of the adhesion detection switch Sw, the main positive switch Sp, the pre-charge switch Spr, and the main negative switch Sn in turn. The power battery system of the present application may include a control unit (not shown) to perform an adhesion detection procedure of the present application. This exemplary adhesion detection procedure is shown in FIG. 4.

Referring to FIG. 4, at step S1, after the power battery system is activated, the adhesion detection of the switches in the power battery system is started.

Next, at step S2, the adhesion detection switch Sw, the pre-charge switch Spr, the main positive switch Sp, and the main negative switch Sn are all in a disconnected state.

Next, in Step S3, it is determined whether the sampling voltage Upr = 0 is met. If the judgment result is no, it proceeds to Step S4; if the judgment result is yes, it proceeds to Step S5.

At step S4, it is determined that the adhesion detection switch Sw is short-circuited (adhesive), then it proceeds to Step S18.

At Step S5, it is determined that the adhesion detection switch Sw is normal and then it proceeds to Step S6.

At Step S6, the pre-charge switch Spr is closed, the adhesion detection switch Sw, the main positive switch Sp, and the main negative switch Sn remain disconnected.

Next, in Step S7, it is judged whether the sampling voltage Upr = 0 is met. If the result is no, it proceeds to Step S8; if the result is yes, it proceeds to Step S9.

At Step S8, it is determined that the main positive switch Sp is adhesive and then it proceeds to Step S18.

At Step S9, it is determined that the main positive switch Sp is normal, then it proceeds to Step S10.

At Step S10, the main negative switch Sn is closed, the pre-charge switch Spr is disconnected, the adhesion detection switch Sw is closed (conducted), and the main positive switch Sp is left disconnected.

Next, in Step S11, it is determined whether the capacitor voltage Udc = 0 is met. If the judgment result is no, it proceeds to Step S12; if the judgment result is yes, it proceeds to Step S13.

At Step S12, it is determined that the pre-charge switch Spr is adhesive and then it proceeds to Step S18.

At Step S13, it is determined that the pre-charge switch Spr is normal and then it proceeds to Step S14.

At Step S14, the main negative switch Sn is disconnected, the pre-charge switch Spr is closed, the adhesion detection switch Sw is held closed (conducted), and the main positive switch Sp is held disconnected.

Next, in Step S15, it is determined whether the capacitor voltage Udc = 0 is met. If the judgment result is no, it proceeds to Step S16; if the judgment result is yes, it proceeds to Step S17.

At Step S16, it is determined that the main negative switch Sn is adhesive and then it proceeds to Step S18.

At Step S17, it is determined that the main negative switch Sn is normal and then it proceeds to Step S18.

At Step S18, the adhesion detection is ended.

It will be understood that one skilled in the art, under the principles of the present application, may select a variety of suitable switch states and switch state switching sequences for the adhesion (short circuit) detection of each switch in the power battery system in the adhesion detection procedure of the power battery system without necessarily being limited to the example shown in FIG. 4. For example, other switch states may be selected to judge the adhesion of the main positive switch Sp, the pre-charge switch Spr, the main negative switch Sn; and the adhesion detection of the main positive switch Sp, the pre-charge switch Spr, the main negative switch Sn are continuously switchable.

The adhesion detection procedure of the present application also constitutes the adhesion detection method applicable to the power battery system described above, and the adhesion detection method can be executed by the control unit in the power battery system of the present application.

After the adhesion detection process is complete, the pre-charge process may be performed if the adhesion detection switch Sw, the main positive switch Sp, the pre-charge switch Spr, and the main negative switch Sn are all normal. During the pre-charge process, the adhesion detection switch Sw, the main positive switch Sp, and the pre-charge switch Spr remain disconnected in Step 14, i.e., the adhesion detection switch Sw and the pre-charge switch Spr remain closed, the main positive switch Sp remains disconnected, and the main negative switch Sn is controlled to be closed, thereby charging the DC bus capacitor C while monitoring the capacitor voltage Udc value. In this way, the number of switching operations is reduced, and the pre-charging time is shortened, thus reducing the waiting time for the power battery to output electrical energy. When the capacitor voltage Udc is charged to the predetermined sampling voltage, the main positive switch Sp is closed and the pre-charge switch Spr and the adhesion detection switch Sw are disconnected, and the main negative switch Sn remains closed, thereby ending the pre-charge process and the power battery system enters the stage of outputting electrical energy to the load. The predetermined sampling voltage may be a value slightly lower than the battery voltage Ubat, e.g., equal to Ubat-10V.

Further, one skilled in the art can modify the layout of the components involved in switch adhesion detection in the power battery system.

For example, in the modification shown in FIG. 2, unlike the example shown in FIG. 1, the first connection point c between the adhesion detection line 4 and the pre-charge line 3 is located on the pre-charge line 3 between the adhesion detection switch Sw and the pre-charge switch Spr. In this modification, the sampling voltage Upr may be taken from both sides of the adhesion detection line 4 or alternatively, the sampling voltage Upr may be taken from both sides of any one or more voltage divider resistors. In this modification, the calculation of the sampling voltage reference value Upr0 is different from the example shown in FIG. 1.

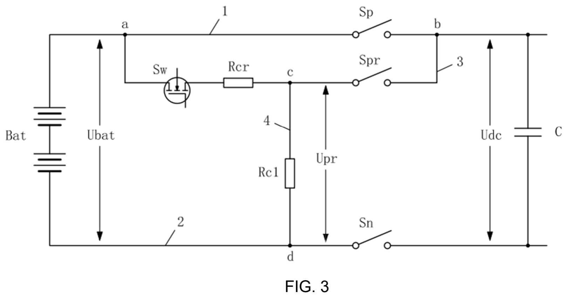

As another example, in the modification shown in FIG. 3, unlike the example shown in FIG. 1, the adhesion detection line 4 comprises only one voltage divider resistor Rc1. In this modification, the sampling voltage Upr is taken from both sides of the adhesion detection line 4, i.e., from both sides of the voltage divider resistor Rc1.

As another example, in the modifications not shown, in the pre-charge line 3, the adhesion detection switch Sw, the pre-charge resistor Rcr, and the pre-charge switch Spr may be arranged in a different order from that shown in FIGs. 1 to 3.

It will be understood that in the modification in FIG. 2, it is also possible to provide only one voltage divider resistor in the adhesion detection line 4.

Regardless of the layout of the components involved in switch adhesion detection in the power battery system, the adhesion detection process described above can be used to detect adhesion in each switch.

According to the power battery system of the present application and a method of switch adhesion detection thereof, the addition of an adhesion detection switch to the pre-charge line and the addition of an adhesion detection line between the pre-charge line and the negative bus bar can achieve the adhesion detection of the main positive switch, the main negative switch, and the pre-charge switch in a single detection process to avoid system malfunctions in the case of switch adhesion. In addition, in the case of main positive switch adhesion, it is possible to promptly detect the adhesion of the main positive switch, preventing the main negative switch from closing while the main positive switch is adhesive, thus avoiding subsequent adhesion of the main negative switch due to internal arcing. In addition, the connection point between the adhesion detection line and the pre-charge line is on the battery side of the pre-charge switch, and the connection point between the adhesion detection line and the negative bus bar is on the battery side of the main negative switch, thus achieving complete electrical separation between the battery side and the load side, improving the high-voltage safety of the power battery system.

While the present application is described herein with reference to specific embodiments, the scope of the present application is not limited to the details shown. Various modifications may be made to these details without departing from the principles of the present application.

## Claims

1. A power battery system, comprising
a power battery (Bat);
a positive bus bar (1) and a negative bus bar (2), respectively connected to positive and negative terminals of the power battery (Bat), for outputting electrical energy of the power battery (Bat) to a power load, a main positive switch (Sp) being provided in the positive bus bar (1), and a main negative switch (Sn) being provided in the negative bus bar (2);
a DC bus capacitor (C) connected between a load side of the positive bus bar (1) and a load side of the negative bus bar (2);
a pre-charge line (3) connected to the positive bus bar (1) on the battery side of the main positive switch (Sp) and the load side, an adhesion detection switch (Sw), a pre-charge resistance (Rcr), and a pre-charge switch (Spr) being provided on the pre-charge line (3); and
an adhesion detection line (4) connected between the pre-charge line (3) and the negative bus bar (2), the adhesion detection line (4) including at least one voltage divider resistor (Rc1);
wherein, a connection point between the adhesion detection line (4) and the pre-charge line (3) is located on the battery side of the pre-charge switch (Spr), and a connection point between the adhesion detection line (4) and the negative bus bar (2) is located on the battery side of the main negative switch (Sn).

2. The power battery system according to claim 1, wherein in the pre-charge line (3), both the adhesion detection switch (Sw) and the pre-charge resistor (Rcr) are located on the battery side of the pre-charge switch (Spr).

3. The power battery system according to claim 1 or 2, wherein the connection point between the adhesion detection line (4) and the pre-charge line (3) is on the battery side of the pre-charge resistor (Rcr).

4. The power battery system according to any one of claims 1 to 3, wherein the power battery system is configured to be capable of performing an adhesion detection procedure, the adhesion detection procedure comprising:
obtaining a battery voltage (Ubat) on both sides of the power battery (Bat), a capacitor voltage (Udc) on both sides of a DC bus capacitor (C), and a sampling voltage (Upr) on the adhesion detection line (4) under various different combinations of switch states based on the on/off status of the adhesion detection switch (Sw), the main positive switch (Sp), the main negative switch (Sn), and the pre-charge switch (Spr);
determining the adhesion of the adhesion detection switch (Sw), the main positive switch (Sp), the main negative switch (Sn), and the pre-charge switch (Spr) based on the on-off state of each of the various combinations of switch states and the values of the capacitor voltage (Udc) and the sampling voltage (Upr).

5. The power battery system according to claim 4, wherein the adhesion detection line (4) includes a plurality of voltage divider resistors, a sampling voltage (Upr) taken from both sides of all the voltage divider resistors, or from both sides of at least one voltage divider resistor of the plurality of voltage divider resistors.

6. The power battery system according to claim 4 or 5, wherein in the adhesion detection procedure, an adhesion detection switch (Sw) detection is performed first, in which it is determined whether the adhesion detection switch (Sw) is short-circuited based on the value of the sampling voltage (Upr).

7. The power battery system according to any one of claims 4 to 6, wherein in the adhesion detection procedure, the main positive switch (Sp), the main negative switch (Sn), and the pre-charge switch (Spr) are individually judged to be adhesive or not by three different combinations of switch states.

8. The power battery system according to any one of claims 4 to 6, wherein in the adhesion detection procedure, the main positive switch (Sp), the main negative switch (Sn), and the pre-charge switch (Spr) are judged to be adhesive or not by more than three different combinations of switch states, and redundant judgment results are used to verify each other.

9. The power battery system according to any one of claims 4 to 8, wherein in the adhesion
detection procedure, in each combination of switch states, at most only one of the main positive switch (Sp), the main negative switch (Sn), and the pre-charge switch (Spr) is closed.

10. The power battery system according to any one of claims 4 to 9, wherein in the adhesion detection procedure, the main positive switch (Sp) remains disconnected in each combination of switch states.

11. The power battery system according to any one of claims 4 to 10, wherein the adhesion detection procedure comprises:
first, with the combination of switch states where the adhesion detection switch (Sw), the main positive switch (Sp), the main negative switch (Sn), and the pre-charge switch (Spr) are all disconnected, it is determined whether the adhesion detection switch (Sw) is short-circuited based on the value of the sampling voltage (Upr).

12. The power battery system according to claim 11, wherein after determining that the adhesion detection switch (Sw) is normal, it is determined whether the main positive switch (Sp) is adhesive based on the value of the sampling voltage (Upr), under the combination of switch states where the adhesion detection switch (Sw) is disconnected, the main positive switch (Sp) is disconnected, the pre-charge switch (Spr) is closed, and the main negative switch (Sn) is disconnected.

13. The power battery system according to claim 11 or 12, wherein after determining that the adhesion detection switch (Sw) is normal, it is determined whether the pre-charge switch (Spr) is adhesive based on the value of the capacitor voltage (Udc), under the combination of switch states where the adhesion detection switch (Sw) is closed, the main positive switch (Sp) is disconnected, the pre-charge switch (Spr) is disconnected, and the main negative switch (Sn) is closed.

14. The power battery system according to any one of claims 11 to 13, wherein after determining that the adhesion detection switch (Sw) is normal, it is determined whether the main negative switch (Sn) is adhesive based on the value of the capacitor voltage (Udc), under the
combination of switch states where the adhesion detection switch (Sw) is closed, the main positive switch (Sp) is disconnected, the pre-charge switch (Spr) is closed, and the main negative switch (Sn) is disconnected.

15. A method for detecting switch adhesion in a power battery system according to any one of claims 1 to 3, comprising:
obtaining a battery voltage (Ubat) on both sides of a power battery (Bat), a capacitor voltage (Udc) on both sides of a DC bus capacitor (C), and a sampling voltage (Upr) on an adhesion detection line (4) under various different combinations of switch states based on the on/off status of an adhesion detection switch (Sw), a main positive switch (Sp), a main negative switch (Sn), and a pre-charge switch (Spr);
determining the adhesion of the adhesion detection switch (Sw), the main positive switch (Sp), the main negative switch (Sn), and the pre-charge switch (Spr) based on the on/off status of each switch in the various combinations of switch states and the values of the capacitor voltage (Udc) and the sampling voltage (Upr);
optionally, the method for detecting switch adhesion further comprises the features defined in any one of claims 5 to 14.
